# EUROPEAN PATENT APPLICATION

(11) **EP 3 242 331 A1**
(43) Date of publication of application: **08.11.2017**
(21) Application number: 16199614.5
(22) Date of filing: 18.11.2016
(51) Int. Cl.: H01L 31/02, H02S 40/34

(54) **FAIL-SAFE DISCONNECT JUNCTION BOX AND SOLAR POWER SYSTEM**

(30) Priority: 03.05.2016 CN 201610293932
(71) Applicant: Shine Charm Limited, Victoria Mahe (SC)
(72) Inventor: YU, Yi, Cixi, Zhejiang (CN)
(74) Representative: Sun, Yiming

(57) **Abstract**

The invention discloses a fail-safe disconnect junction box for a solar photovoltaic module and a power station system, wherein the junction box comprises a box body, the box body is provided with a printed circuit board, the printed circuit board is printed with N bus bar connecting ends and two cable connecting ends, each bus bar connecting end is connected with a solar battery pack strand via bus bars, two adjacent bus bar connecting ends are further connected via a diode; wherein an electronic switch is connected between the first bus bar connecting end and the first cable connecting end in series, the electronic switch is controlled to turn on or off via a received control signal; the Nth bus bar connecting end is connected with the second cable connecting end; and two cable connecting ends are connected to the outside via a cable respectively. The power station system controls the junction box via the control signal. According to the invention, the voltage in the power station system will be reduced within a safety range manually or automatically when an accident happens, thus facilitating carrying out site disposal in time.

## Description

### Technical Field

The present invention belongs to the field of solar photovoltaic power generation technology, and more particular, to a fail-safe disconnect junction box for a solar photovoltaic module, and a solar photovoltaic power station system using the junction box.

### Background Art

In recent years, the solar photovoltaic power generation is developed rapidly. The basic structure thereof includes solar battery pack strands installed on a bracket and a junction box configured to connect the battery pack strands. Wherein, the junction box is a very important accessory for electrical connection of the solar photovoltaic modules. The voltage generated by the solar battery pack strand is accumulated via the junction box, and then the direct current is converted into the alternating current via an inverter, and incorporated into the power grid. In the prior art, the structure of the junction box generally includes a box body, the box body is provided with a plurality of conducting pieces, which are connected with solar battery pack strands via bus bars respectively; a diode is connected between two adjacent conducting pieces; and the conducting pieces at both ends are connected to the outside via cables respectively. The pluralities of junction boxes are connected in series to accumulate the voltage generated by the battery pack strand. The existing junction box does not possess the on-off function, in other words, the electric connection is also in existence all the time as long as the physical connection is connected, and the voltage is extremely high; in the common design scheme, the voltage generated by single battery pack strand is 30V, and the voltage can reach up to 420V after the series connection of 14 groups. In this way, when incidents like fire and earthquake happen in the power station, rescue workers will be prevented from coming to the rescue in time as the system still possesses the higher voltage.

### Summary of the Invention

An object of the present invention is to provide a fail-safe disconnect junction box for a solar photovoltaic module, which can disconnect the power in time when required.

Another object of the present invention is to provide a solar photovoltaic power station system using the junction box, so as to drop the voltage in time at the direct current side.

In order to achieve the first invention object, the technical solution employed in the present invention is as follows: a fail-safe disconnect junction box for a solar photovoltaic module comprises a box body, wherein the box body is provided with a printed circuit board, the printed circuit board is printed with N bus bar connecting ends and two cable connecting ends, each bus bar connecting end is connected with a solar battery pack strand via bus bars, two adjacent bus bar connecting ends are further connected via a diode; wherein an electronic switch is connected between the first bus bar connecting end and the first cable connecting end in series, the electronic switch is controlled to turn on or off via a received control signal; the Nth bus bar connecting end is connected with the second cable connecting end; and two cable connecting ends are connected to the outside via a cable respectively.

The logic of the electronic switch is as follows: the switch is cut off if no signal is provided, while the switch is turned on if the signal is provided.

Further, a bypass diode is bridged between two cable connecting ends.

The bus bar connecting end, the diode, the cable connecting end, the bypass diode and the electronic switch constitute a main circuit of the junction box together, a sampling amplification circuit is further connected between the bus bar connecting end and the corresponding cable connecting end, and the output end of the sampling amplification circuit is connected with the electronic switch.

The bus bar connecting end, the diode, the cable connecting end, the bypass diode and the electronic switch constitute the main circuit of the junction box together, the sampling amplification circuit is further bridged between two cable connecting ends, and the output end of the sampling amplification circuit is connected with the electronic switch.

The negative pole bus bar connecting end is the first bus bar connecting end, and the negative pole cable connecting end is the first cable connecting end.

In order to achieve the second invention object, the employed technical solution is as follows: a solar photovoltaic power station system comprises a plurality of solar battery pack strands, which are connected as a group via a junction box in series, direct current is converted into alternating current via an inverter after accumulating the generated voltage, wherein at least part of the junction box is the fail-safe disconnect junction box mentioned above; the power station system is provided with a control signal generator, and an electronic switch in the fail-safe disconnect junction box is controlled by a control signal to turn on or off.

Further, the control signal generator is connected into a loop in series or in parallel, and the generated control signal is transmitted to various junction boxes via a cable; or, the control signal generator generates a wireless signal to transmit to various junction boxes.

It can be observed that from the description for the fail-safe disconnect junction box, the first bus bar connecting end and the first cable connecting end have the corresponding relation and form a group; and the Nth bus bar connecting end and the second cable connecting end have the corresponding relation and form as a group. In a general way, the groups are located at both sides of a printed circuit board respectively as a positive pole or a negative pole. When the sampling amplification circuit is connected in the main circuit in series, there may be two modes, one of which is that one electronic switch is connected between the first bus bar connecting and the first cable connecting end in series, and the sampling amplification circuit is connected between the Nth bus bar connecting end and the second cable connecting end; and the other of which is that one electronic switch and the sampling amplification circuit are connected between the first bus bar connecting and the first cable connecting end in series, and the Nth bus bar connecting end and the second cable connecting end are connected directly.

The function of the sampling amplification circuit is to sample the control signal. The control signal can be either a carrier signal in the loop or a wireless signal, and then is amplified to transmit to the electronic switch.

The electronic switch possesses two logics for selection, i.e., defaulting as connect or disconnect. If defaulting as connect, the switch is turn on when no signal is provided and the switch is cut off when the signal is provided; and if defaulting as disconnect, the switch is cut off when no signal is provided and the switch is turn on when the signal is provided. In the present invention, the solution of defaulting as disconnect is preferred. This is because that when the incidents happen, the control signal may automatically loss due to the incidents, and the junction box will automatically cut off. In this way, it is more beneficial to achieve the invention purpose of "cutting off in time in an emergency condition".

The electronic switch in the present invention needs an additional power supply circuit. The electronic switch is arranged between the negative pole bus bar connecting end and the cable connecting end, can share the ground connection with the junction box and is relatively arranged on the positive pole, which optimize the design and save the cost. The bypass diode between the cable connecting ends possesses the vital function. Under the initial state, no loop is formed among various junction boxes as the default state of the electronic switch is disconnected, so the control signal cannot reach various junction boxes to start the whole system. Therefore, the setting of the bypass diode can enable the system to successfully start under the initial state. When certain junction box or the battery pack strand connected thereto is broken down, the bypass diode is also needed for communicating to form the loop, so that the other junction boxes connected in series and the battery pack strands can work normally.

The power station system of the invention controls the junction box via the control signal. As one control signal controls the plurality of junction boxes simultaneously, the plurality of junction boxes will be disconnected when the signal is reversed, so as to disconnect the solar battery pack strands. If each junction box is provided with the electronic switch, the voltage in the power station system is that generated by the single battery pack strand after the switch is cut off, and the voltage is about 30V according to the foregoing example; if one of every two junction boxes is provided with the electronic switch, the voltage in the power station system is that generated by two battery pack strands after the switch is cut off, and the voltage is about 60V according to the foregoing example, and so forth.

The electronic switch can be controlled by the control signal in the wired or wireless mode. The wireless mode includes WIFI, radio frequency, Bluetooth and other various modes for selection. The wired mode can utilize the original cable to send in the form of carrier signal. The control signal generator can be connected with the junction box in series or in parallel.

It can be observed that from the foregoing description, the voltage in the power station system will be reduced within a safety range manually or automatically when an accident happens according to the technical solution of the invention, thus facilitating carrying out site disposal in time.

### Brief Description of the Drawings

The present invention is further described in details hereinafter by reference to the drawings and the exemplary embodiments of the present invention.
Fig. 1 is a system block diagram of a power station system;
Fig. 2 is a circuit diagram of a junction box;
Fig. 3 is a main circuit diagram A1 of the junction box;
Fig. 4 is a sampling amplification circuit diagram A2 of the junction box;
Fig. 5 is a driving output circuit A3 of the junction box;
Fig. 6 is a power supply circuit A4 of the junction box;
Fig. 7 is a circuit diagram of the power station system;
Fig. 8 is a simulation circuit diagram of a control signal generator; and

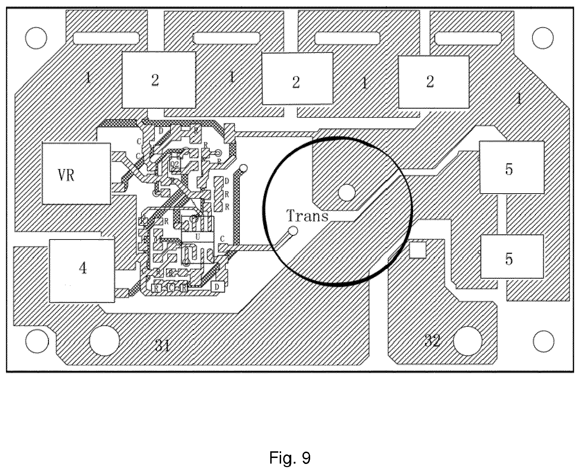

Fig. 9 is a PCB diagram of a junction box.

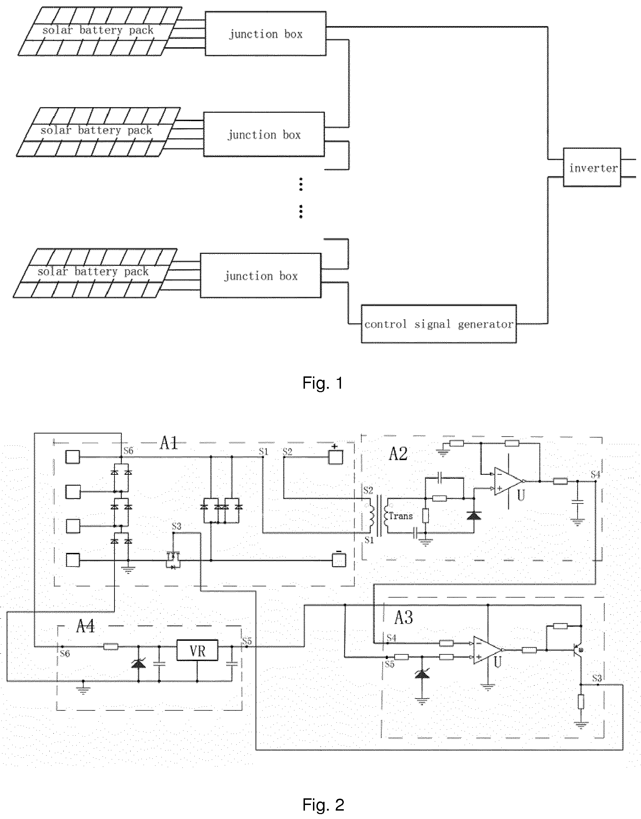

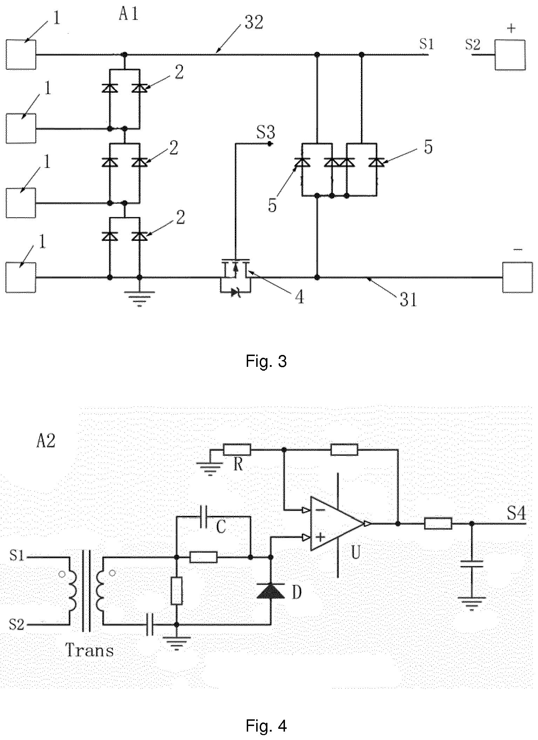

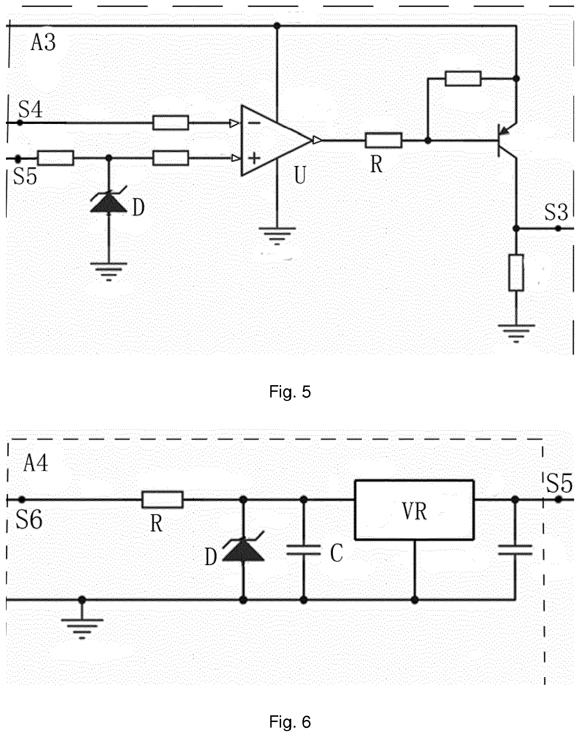

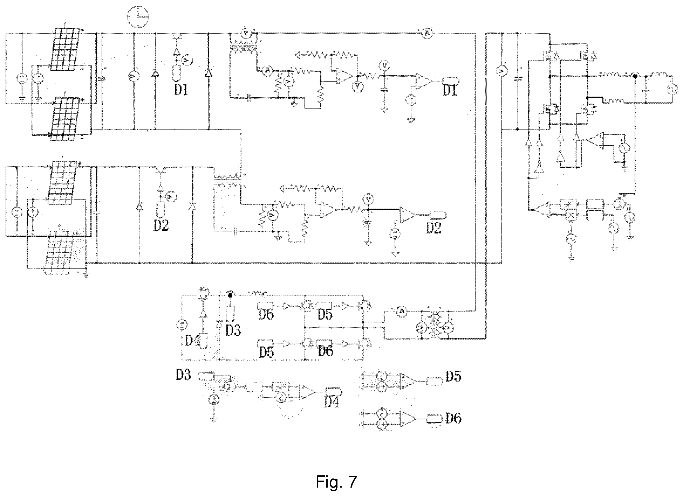

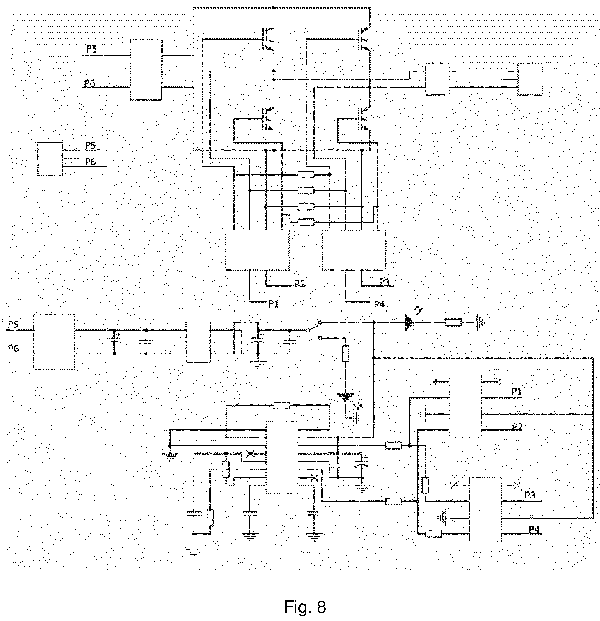

Marks in figures: bus bar connecting end 1, diode 2, negative pole cable connecting end 31, positive pole cable connecting end 32, electronic switch 4, bypass diode 5. U is operational amplifier, R is resistor, C is capacitor, D is diode, Q2 is triode, VR is potentiometer, and Trans is iron-core transformer.
wherein, D1, D2, D3, D4, D5 and D6 in Fig 2 are connecting ends, and two ends in the same label are connected;
S1, S2, S3, S4 and S5 in Fig. 3 to Fig. 7 are connecting ends, and two ends in the same label are connected;
P1, P2, P3, P4, P5 and P6in Fig. 8 are connecting ends, and two ends in the same label are connected.

### Detailed Description of the Preferred Embodiments

Referring to the drawings, a fail-safe disconnect junction box described in the embodiment includes a box body, wherein the box body is provided with a printed circuit board, the printed circuit board is printed with N bus bar connecting ends 1 and cable connecting ends, the cable connecting ends are divided into a negative pole cable connecting end 31 and a positive pole cable connecting end 32; each bus bar connecting end 1 is connected with a solar battery pack strand via bus bars, two adjacent bus bar connecting ends 1 are further connected via a diode 2; wherein an electronic switch 4 is connected between the first bus bar connecting end and the negative pole cable connecting end 31 in series, the electronic switch 4 is controlled to turn on or off via a received control signal; the Nth bus bar connecting end is connected with the positive pole cable connecting end 32; and two cable connecting ends are connected to the outside via a cable respectively. A bypass diode 5 is bridged between two cable connecting ends; The bus bar connecting end 1, the diode 2, the cable connecting end 3, the bypass diode 5 and the electronic switch 4 constitute a main circuit of the junction box together, a sampling amplification circuit is further connected in series or bridged in part S1 and Part S2 between the bus bar connecting end and the corresponding cable connecting end, and the output end of the sampling amplification circuit is connected with the electronic switch 4.

The solar photovoltaic power station system described in the embodiment includes a plurality of solar battery pack strands, which are connected as a group via a junction box in series, direct current is converted into alternating current via an inverter after accumulating the generated voltage, wherein at least part of the junction box is the fail-safe disconnect junction box; the power station system is provided with a control signal generator, and an electronic switch in the fail-safe disconnect junction box is controlled by a control signal to turn on or off. The control signal generator can be connected into a loop in series or in parallel, and the generated control signal can be transmitted to various junction boxes in a wired manner, i.e., a cable, or a wireless signal can be generated in a wireless manner, i.e., WIFI, radio frequency, Bluetooth and the like to transmit to various fail-safe disconnect junction boxes.

When the embodiment is working, the fail-safe disconnect junction box is controlled by the control signal sent from the control signal generator. At the initial phase, multiple groups of battery pieces provide power for the junction box normally; when a special situation occurs, the control signal generator sends out a reverse signal, the electronic switch inside the junction box is cut off; as one control signal controls the plurality of fail-safe disconnect junction box simultaneously, the control signal generator sends out the reverse signal, the electronic switches inside the plurality of junction boxes are cut off to disconnect the solar battery pieces. In this way, the voltage in the power station system is that generated by the single group of battery pieces. The voltage in the power station system is reduced within the safety range, thereby facilitating carrying out site disposal in time.

## Claims

1. A fail-safe disconnect junction box for a solar photovoltaic module, comprising a box body, wherein the box body is provided with a printed circuit board, the printed circuit board is printed with N bus bar connecting ends and two cable connecting ends, each bus bar connecting end is connected with a solar battery pack strand via bus bars, two adjacent bus bar connecting ends are further connected via a diode; wherein an electronic switch is connected between the first bus bar connecting end and the first cable connecting end in series, the electronic switch is controlled to turn on or off via a received control signal; the Nth bus bar connecting end is connected with the second cable connecting end; and two cable connecting ends are connected to the outside via a cable, respectively.

2. The fail-safe disconnect junction box for the solar photovoltaic module according to claim 1, wherein the logic of the electronic switch is as follows: the switch is cut off if no signal is provided, while the switch is turn on if the signal is provided.

3. The fail-safe disconnect junction box for the solar photovoltaic module according to claim 2, wherein a bypass diode is bridged between two cable connecting ends.

4. The fail-safe disconnect junction box for the solar photovoltaic module according to claim 3, wherein the bus bar connecting end, the diode, the cable connecting end, the bypass diode and the electronic switch constitute a main circuit of the junction box together, a sampling amplification circuit is further connected between the bus bar connecting end and the corresponding cable connecting end, and the output end of the sampling amplification circuit is connected with the electronic switch.

5. The fail-safe disconnect junction box for the solar photovoltaic module according to claim 3, wherein the bus bar connecting end, the diode, the cable connecting end, the bypass diode and the electronic switch constitute the main circuit of the junction box together, the sampling amplification circuit is further bridged between two cable connecting ends, and the output end of the sampling amplification circuit is connected with the electronic switch.

6. The fail-safe disconnect junction box for the solar photovoltaic module according to any one of claims 1 to 5, wherein the negative pole bus bar connecting end is the first bus bar connecting end, and the negative pole cable connecting end is the first cable connecting end.

7. A solar photovoltaic power station system, comprising a plurality of solar battery pack strands, which are connected as a group via a junction box in series, direct current is converted into alternating current via an inverter after accumulating the generated voltage, wherein at least part of the junction box is the fail-safe disconnect junction box according to any one of claims 1 to 6; the power station system is provided with a control signal generator, and an electronic switch in the fail-safe disconnect junction box is controlled by a control signal to turn on or off.

8. The solar photovoltaic power station system according to claim 7, wherein the control signal generator is connected into a loop in series or in parallel, and the generated control signal is transmitted to various junction boxes via a cable.

9. The solar photovoltaic power station system according to claim 7, wherein the control signal generator generates a wireless signal to transmit to various junction boxes.
